# EUROPEAN PATENT SPECIFICATION

(11) **EP 3 484 939 B1**
(45) Date of publication and mention of the grant of the patent: **02.06.2021**
(21) Application number: 16738417.1
(22) Date of filing: 12.07.2016
(51) Int. Cl.: C08G 59/68, C08G 59/72, C08G 59/24, H01B 3/40

(54) **USE OF AN EPOXY RESIN COMPOSITION AND POWER PRODUCT WITH EPOXY RESIN COMPOSITION**
VERWENDUNG EINER EPOXIDHARZZUSAMMENSETZUNG UND ENERGIEPRODUKT MIT EPOXIDHARZZUSAMMENSETZUNG
UTILISATION D'UNE COMPOSITION DE RÉSINE ÉPOXY ET PRODUIT ÉLECTRIQUE CONSTITUÉ DE LA COMPOSITION DE RÉSINE ÉPOXY

(43) Date of publication of application: 22.05.2019
(73) Proprietor: ABB Power Grids Switzerland AG, 5400 Baden (CH)
(72) Inventor: SCHEEL, Saskia, 5600 Lenzburg (CH); TZAVALAS, Spiros, 74182 Obersulm (DE); HO, Chau-Hon, 79540 Lörrach (DE)
(74) Representative: Epping - Hermann - Fischer
(86) International application number: PCT/EP2016/066539
(87) International publication number: WO 2018/010768

(56) References cited:
- WO-A1-2009/046755
- WO-A1-2011/023227
- WO-A1-2017/001182
- CA-A1- 2 207 782
- US-A- 4 131 600
- US-A- 5 064 882
- US-A- 6 048 946

## Description

### FIELD OF INVENTION

The present disclosure refers to the use of an epoxy resin composition in an electrical insulation for insulating a power product, and to a power product including insulation with the epoxy resin composition. Moreover, the present disclosure refers to a power product for medium and/or high voltage power transmission or distribution comprising a conductor surrounded by the electrical insulation material including the epoxy resin composition.

### STATE OF THE ART

Epoxy resins may cure via several reactions, e.g. copolymerization or homopolymerization. For copolymerization, hardeners are used. For instance, the use of anhydride hardeners for curing epoxy resins is known in literature, including several low anhydride content (5-10 wt%) concepts as well as epoxy resins with grafted anhydride groups. Also, curing of epoxy resins takes place in the presence of alternative hardeners, such as amine hardeners. For homopolymerization, various catalyst/accelerator systems are known to cure epoxy resins without using any hardeners.

Current electrical outdoor applications have used a mixture of an epoxy resin and a hardener (mostly anhydrides) which has various advantages, e.g., they are well investigated, proven to work and well accepted by customers.

As hardeners, non-aromatic anhydrides such as MHHPA (methyl hexahydrophthalic anhydride) or HHPA (hexahydrophthalic anhydride) have been primarily used to produce insulation systems e.g. in outdoor instrument transformers and outdoor reclosers. These hardeners may generate serious health issues due to sensitization caused by long term exposure to anhydride vapors produced during processing. Consequently, both hardeners were added on REACH candidate list for SVHC (Substances of Very High Concern) in 2012. On November 18, 2015, ECHA published the 7^{th} draft recommendation adding the anhydrides for inclusion in the Authorization List (Annex XIV).

Since epoxy resins bearing aromatic moieties undergo degradation due to UV radiation, they are not adequate for outdoor use. Instead, where outdoor stability or low viscosity is a desired property, cycloaliphatic epoxy resins have been used. For instance, specific cycloaliphatic epoxies have been used to avoid tracking and erosion.

Accordingly, the current material for electrical outdoor applications is based on cycloaliphatic epoxy resin systems including a hardener, such as anhydrides. However, since anhydrides are volatile, anhydrides may generate sensitization via inhalation and were added to the REACH Candidate List for SVHC (substances of very high concern), new anhydride-free epoxy resin formulations for outdoor applications are needed

In view of the above, the use of an epoxy resin composition and a power product including an insulation with an epoxy resin composition are provided that solve at least some of the problems of the systems known in the art.

Document CA 2 207 782 A1 as well as document US 6 048 946 A describe an epoxy resin composition.

### BRIEF DESCRIPTION OF THE INVENTION

In view of the above, the use of an epoxy resin composition according to claims 1 and 2, and a power product having insulation with an epoxy resin composition according to claim 15 are provided. Further aspects, advantages, and features of the present invention are apparent from the dependent claims, the description, and the accompanying drawings.

According to an aspect of the invention, the use of an epoxy resin composition in an outdoor application of an electrical insulation is provided. The epoxy resin composition includes an aliphatic epoxy resin and a catalyst system. The catalyst system is present in the epoxy resin composition in content of about 0.5 phr to about 5 phr (parts per hundred parts of resin). The catalyst system includes a BX₃ amine complex. According to embodiments described herein, the epoxy resin composition is substantially anhydride-free.

According to a further aspect of the invention, the use of an epoxy resin composition in a medium or high voltage application (MV and HV) of an electrical insulation is provided. The epoxy resin composition includes an aliphatic epoxy resin and a catalyst system. The catalyst system is present in the epoxy resin composition in content of about 0.5 phr to about 5 phr (parts per hundred parts of resin). The catalyst system includes a BX₃ amine complex. According to embodiments described herein, the epoxy resin composition is substantially anhydride-free

In particular, the present invention further refers to the use of the epoxy resin composition as described in embodiments herein for electrically insulating electrical components such as machines, bushings and transformers and other insulating components.

Embodiments described herein provide an epoxy resin composition without anhydrides (i.e. anhydride-free epoxy compositions) for electrical outdoor applications and/or medium and high voltage applications which have the same or similar properties regarding the electrical and mechanical behavior as the anhydride-containing epoxy systems currently used. The currently used material for electrical outdoor applications is e.g. based on cycloaliphatic epoxy resin systems including a hardener, such as anhydrides. However, since anhydrides are volatile, they may generate sensitization via inhalation and were added to the REACH Candidate List for SVHC (substances of very high concern), new anhydride-free epoxy resin formulations for outdoor applications are beneficial.

Even if homopolymerization without using anhydride hardeners is a feasible way, a closer look to the electrical and mechanical properties of such homopolymerized epoxy systems has not happened yet. One of the biggest challenges is the inferior tracking and erosion and cracking properties at low temperatures.

According to the present inventors' knowledge, so far, homopolymerized epoxy materials meeting the requirements for outdoor applications have not yet been described in literature. The present inventors investigated that epoxy resin systems without any hardener repeatedly fail the 3.5 kV level of the inclined tracking and erosion test (class 1A3.5 according to standard IEC 60587) used and beneficial for electrical outdoor applications. Also, the resistance of cracking at low temperatures for such epoxy resin systems has not been investigated yet.

Embodiments described herein resolve the above-outlined drawbacks of currently available epoxy resin systems. In particular, embodiments described herein provide the use of an epoxy resin compositions which does not include anhydrides and which still fulfill the electrical and mechanical requirements of outdoor products, in particular MV outdoor products. The electrical and mechanical properties are especially considered and tested regarding tracking & erosion and cracking at low temperatures. Specifically, the present invention provides the use of an epoxy resin composition which is curable (in particular homopolymerizable) in the presence of a catalyst in a small concentration (0.5-5 phr), passes the 4.5 kV level test and shows cracking resistance at low temperatures

According to a further aspect of the invention, a power product for outdoor applications is provided. The power product according to embodiments described herein includes an insulation, wherein the insulation includes an epoxy resin composition. The epoxy resin composition according to embodiments described herein includes a hydrophobic, cycloaliphatic resin and a catalyst system. The catalyst system is present in the epoxy composition in content of about 0.5 phr to about 5 phr. The catalyst system includes a BX₃ amine complex. The epoxy resin composition in the insulation of a power product according to embodiments described herein is substantially anhydride-free.

In view of the foregoing, the use of an anhydride-free epoxy resin composition and the power product according to embodiments described herein represent a practicable back-up solution to mitigate the effect of a possible penalization or banning of anhydrides. Specifically, the anhydride-free epoxy resin compositions used in embodiments described herein withstand the mechanical and electrical requirements for electrical outdoor applications such as tracking and erosion tests and cracking at low temperatures without using anhydrides (as will be shown in detail below). The anhydride-free epoxy resin compositions used in embodiments described herein offer a viable alternative to the anhydride-based epoxy materials currently being used for outdoor applications, such as medium and/or high-voltage insulations.

Further embodiments, aspects, advantages and features of the present invention are described in the dependent claims, the description and the accompanying drawings.

In the following, if not otherwise defined, "wt%" (% by weight) refers to the total weight of the respective entity (e.g. the total weight of the epoxy resin composition or the total weight of electrical insulation material). Furthermore, if not otherwise stated, all measurements were carried out at room temperature.

### BRIEF DESCRIPTION OF THE DRAWINGS

Figure 1 shows a comparative example test for tracking and erosion with samples including an epoxy resin composition as known in the art.
Figure 2 shows a sample test for tracking and erosion with samples including an epoxy resin composition as used in embodiments described herein.
Figure 3 shows a diagram of a cracking test and temperature behavior test of samples with an epoxy resin composition used in embodiments described herein.

### DETAILED DESCRIPTION OF THE INVENTION

Reference will now be made in detail to various embodiments and aspects of the invention. Each embodiment and each aspect is provided by way of explanation and is not meant as a limitation. For example, features illustrated or described as part of one embodiment or aspect can be used on or in conjunction with any other embodiment or aspect to yield yet a further embodiment or aspect. It is intended that the present disclosure includes any such combinations and variations.

According to an embodiment, the use of an epoxy resin composition in an outdoor application or a medium and high voltage application of an electrical insulation is provided. The epoxy resin composition includes an aliphatic epoxy resin and a catalyst system. The catalyst system is present in the epoxy resin composition in content of about 0.5 phr to about 5 phr (parts per hundred parts of resin). The catalyst system includes a BX₃ amine complex. According to embodiments described herein, the epoxy resin composition is substantially anhydride-free.

An "outdoor application" as used herein may be understood as an application of an electrical insulation (e.g. an insulation of a medium high voltage power product) in outdoor environmental circumstances. For instance, the environmental circumstances may include temperature, pressure, humidity, radiation (e.g. UV radiation), and the like. In one example, which may be combined with other embodiments described herein, the environmental circumstances of an outdoor application may include at least one of the following parameters or conditions: the temperature ranging between about -80°C and about +70°C, the humidity being up to 100%, the light intensity, the light wavelength, the UV index being up to 11, the UV intensity, conditions depending on the height of the place of use (such as high UV radiation, lowered oxygen content, lowered pressure), (fast) air pressure changes, the air pollution (e.g. with mold growth, pesticides, herbicides, pollen, bird droppings, acid rain, acid fog), the salinity of the ambient air (e.g. a salinity of between 200 microSiemens/cm to 200 000 microSiemens/cm or the conductivity of the saline solution when the air is condensed), the alkalinity of the ambient air, the acidity of the ambient air, and the like. Generally, all conditions on the Earth on the ground (not in the water), which are not indoor, may contribute to outdoor parameters. According to some embodiments, which may be combined with other embodiments described herein, at least one of the following standards may be used for outdoor applications: CIGRE 333 (Guide for the establishment of naturally polluted insulator testing stations); CIGRE 631 (Coating for protecting overhead power network equipment in winter conditions); CIGRE 158 (Polluted insulators: a review of current knowledge); IEC/TS 60815-3 (Selection and dimensioning of HV insulators for use in polluted conditions, especially Part 3: Polymer insulators for A.C. system); IEC TR 62039 (Selection guide for polymeric materials for outdoor use under HV stress); and CEI IEC 507 (Artificial pollution tests on high voltage insulators to be used on A.C. systems).

According to some embodiments, a medium voltage (MV) or a high voltage (HV) application may be understood as an application of the epoxy resin composition in power product which has a defined rated voltage, in particular a rated voltage in the MV or HV range. According to some embodiments, a MV application may have a rated voltage larger than 1kV, such as a rated voltage between 1kV and 35kV For instance, a high voltage application may include applications at a rated voltage being typically larger than 35 kV, such as a rated voltage between 35 kV and 230 kV, or larger than 230kV, such as 640 kV or higher than 640 kV. According to some embodiments, the epoxy resin composition may also be used in a high current application according to embodiments described herein. For instance, a high current application of the epoxy resin composition in power product has a defined rated current, in particular a rated current of more than 1000 A.

According to some embodiments, the epoxy resin composition includes a catalyst system. The catalyst system includes a BX₃ amine complex. The catalyst system may in some embodiments include further components. For instance, the catalyst system may include one or more co-catalyst(s), accelerators, catalyst-activating agents, binders, active binders, and the like.

The term "substantially" as used herein may mean that there may be a certain deviation from the characteristic denoted with "substantially." For instance, substantially anhydride-free may include small (e.g. negligible) amounts of anhydrides, such as small amounts of anhydrides that do not or that cannot contribute to hardening of the epoxy resin composition. In some embodiments, the epoxy resin composition being substantially anhydride-free may mean that the composition may include about 0.5wt% or less anhydrides. According to some embodiments, the term "substantially not influencing" a certain property may mean that there may be a small and negligible influence on the respective property. Typically, "substantially not influencing" may mean that there is no influence on the function of the respective part having the named property.

The "X" in the BX₃ amine complex stands for a halegonide, such as Cl or F. The letter "B" stands for the chemical element Boron. For instance, BX₃ may stand for BCl₃ (boron trichloride). The BX₃ amine complex may be a N,N-dimethyl-octyl amino complex of boron trichloride or derivatives of a N,N-dimethyl-octyl amino complex of boron trichloride. In some embodiments, at least one of the materials named Omicure BC120, Astorit ACC 9577, Huntsman DY 9577 ES may be used for the BX₃ amine complex. For instance, each of the above named materials may be used in a concentration of 1.5-2 phr.

According to some embodiments, which may be combined with other embodiments described herein, a blocked super acid is chosen from the group of salts of triflic, fluoroantimonic acid, hexafluoroantimonate, derivatives of hexafluoroantimonate and complexes of hexafluoroantimonate. In some embodiments, the material having the name CXC 1612 may be used, in particular in a concentration of 0.5 phr to 5 phr.

According to some embodiments, which may be combined with other embodiments described herein, the catalyst system may include both a BX₃ amine complex and a blocked super acid. In particular, the catalyst system may include at least one of the above named examples of a BX₃ amine complex and at least one of the above named examples of a blocked super acid.

According to some embodiments, the epoxy composition used in embodiments described herein may include an aliphatic epoxy resin, in particular a cycloaliphatic resin. In one example, the epoxy resin composition used in embodiments described herein includes a cycloaliphatic resin based on a diglycidyl ester of a hexahydrophthalic acid. According to some embodiments, which may be combined with other embodiments described herein, the epoxy resin composition used in embodiments described herein may include a hydrophobic resin, in particular a hydrophobic epoxy resin mixture.

In some embodiments, the epoxy resin composition used in embodiments described herein may further include a filler, in particular a silica filler. In one example, the filler in the epoxy resin composition used in embodiments described herein may be an ultra-fine silica, and in particular a silanized ultra-fine silica. According to some embodiments, which may be combined with other embodiments described herein, the filler may be present in the epoxy resin composition in an amount of between about 50wt% and 70wt%, in particular between about 60 wt% and about 65wt%.

In some embodiments, which may be combined with other embodiments described herein, the epoxy resin composition is a homopolymerized epoxy resin composition.

According to embodiments described herein, the content of the catalyst system in the epoxy resin composition used in embodiments described herein may typically be between about 0.1 phr to about 10 phr, more typically between about 0.2 phr and about 7 phr, and even more typically between about 0.5 phr and about 5 phr. According to some embodiments, which may be combined with other embodiments described herein, the content of the BX₃ amine complex in the epoxy resin composition as used in embodiments described herein may typically be between about 1 phr and about 5 phr, more typically between about 1.5 phr and about 3 phr, and even more typically between about 1.5 phr and about 2phr. In some embodiments, the content of the blocked super acid in the epoxy resin composition used in embodiments described herein is between 0.5 phr and 5 phr.

In some embodiments, the amount of the BX₃ amine complex and/or the blocked super acids may vary dependent on the intended (specific) application of the epoxy resin composition. For instance, the amount of the BX₃ amine complex and/or the blocked super acids may be chosen according to the relevance of defined properties of the epoxy resin composition, in particular in view of outdoor applications and/or medium and high voltage applications. For instance, for desired tracking and erosion properties (which will be explained in detail below), the amount of BX₃ amine complex may be between about 1.5 phr and about 2 phr. The amount of blocked super acid may be between about 0.5 phr and about 5 phr for desired tracking and erosion properties. In some embodiments, in particular if cracking at low temperatures is regarded, the BX₃ amine complex may be present in an amount of about 2 phr in the epoxy composition used in embodiments described herein. The blocked super acids may be present between about 0.5 phr and about 5 phr in the epoxy composition used in embodiments described herein regarding desired properties of cracking at low temperatures. According to some embodiments, low temperatures may typically mean temperatures below about 5°C, more typically temperatures below 0°C.

According to some embodiments, the use of the epoxy resin composition may take place in a power product. According to some embodiments, which may be combined with other embodiments described herein, power product is described having an epoxy resin composition as described and used in embodiments described herein. In particular, power product is described having an epoxy resin composition, which may have every feature of the epoxy resin composition described herein, alone or in combination with other features of the epoxy resin composition described herein.

A power product as referred to herein may be an electrical device, an electrical machine, or a power product for medium and high voltages. For instance, the power product may be (and/or epoxy resin composition used and described in embodiments described herein may be used in) electrical power equipment, in particular switchgears and rotating machines. For instance, a power product may be an electric motor, generator, and/or transformer. The epoxy resin composition may generally be used as cast insulator of a transformer, insulating component of a switchgear, in an electrical conductor for an electrical machine, a stator with an inserted coil of an electrical machine, an electrical conductor for a transformer, and a coil for a transformer, and the like.

According to some embodiments, the epoxy resin composition used in embodiments described herein may be used in several applications and devices. For instance, the applications and devices, for which the epoxy resin composition as described in embodiments herein may be used include in in medium and/or high-voltage insulations for outdoor use, support insulators, current and voltage transformers and sensors, bushings, as impregnating resins, for outdoor insulators associated with high-voltage lines, in long-rods, in composite and cap-type insulators, in base insulators, in the production of insulators associated with outdoor power switches, in measuring transducers, in lead-throughs, in overvoltage protectors, in switchgear constructions, in power switches, dry-type transformers and electrical machines, and in coating materials for transistors and other semiconductor elements.

According to some embodiments, the epoxy resin composition as described in embodiments described herein may beneficially be used for decreasing the tracking and erosion effects in outdoor applications and/or medium and high voltage applications. Tracking and erosion may decrease the material quality and make the material susceptible for material damage and failure (such as breakdowns). For instance, tracking and erosion may lead to increased wear and degeneration of the material. According to some embodiments, the tracking and erosion properties of the epoxy resin composition may be measured by measuring the leakage current in a defined time period. For instance, the tracking and erosion properties of the epoxy resin composition as described in embodiments described herein may be measured by measuring the intensity and duration of leakage current in a defined time period. In some embodiments, which may be combined with other embodiments described herein, the cured epoxy resin composition as described in embodiments herein passes the inclined tracking and erosion test according to standard IEC 60587, class 1A3.5 at 3.5 kV and 4.5 kV. According to embodiments, described herein, the epoxy resin composition has successfully passed the test if the leakage current does not overcome 60 mA for more than 2 seconds in a period of 6 hours.

According to some embodiments, the epoxy resin composition as described in embodiments described herein may beneficially be used for decreasing cracking effects in outdoor applications and/or medium and high voltage applications. Cracking decreases the material quality. For instance, cracking results in small cracks and openings, holes, or slits within the material. In particular regarding the insulation properties beneficially provided by the epoxy resin composition used and described in embodiments described herein, cracking can damage and even destroy the insulation barrier of power products including the epoxy resin composition according to embodiments described herein. According to some embodiments, which may be combined with other embodiments described herein, the epoxy resin composition withstands temperatures of minimum -40°C without cracking. In some embodiments, the term "without cracking" may refer to a state of the material, where no cracks are visible, in particular where no cracks are visible being larger (such as larger in longitudinal direction) than 1 mm. For instance, the term "without cracking" may include small sized or small numbered cracks, which do not substantially influence the insulation properties of the material including the epoxy resin composition used and described in embodiments described herein. For instance, cracks being only present on the surface of the insulating material may fall in the term "without cracking."

In the following, an example of a sample preparation is described.

For preparing the anhydride-free epoxy resin composition, an epoxy resin (100 phr) and silica (60 wt% to 65 wt%) were mixed under ambient conditions, and subsequently further mixed at 70 °C under vacuum of 1-4 mbar until it became bubble-free. The catalyst system according to embodiments described herein was added and degasified for 30 minutes. The epoxy resin composition was poured into the cavity of the mold (treated with a release agent, Frekote 770-NC) and degassed again under the same conditions. For gelling, the material was put for 8h at 100 °C and then cured at 140 °C for 4h.

In Table 1 below, the components used for casting the anhydride-free epoxy resin composition are indicated, Systems 3 and 4 are not part of the invention:

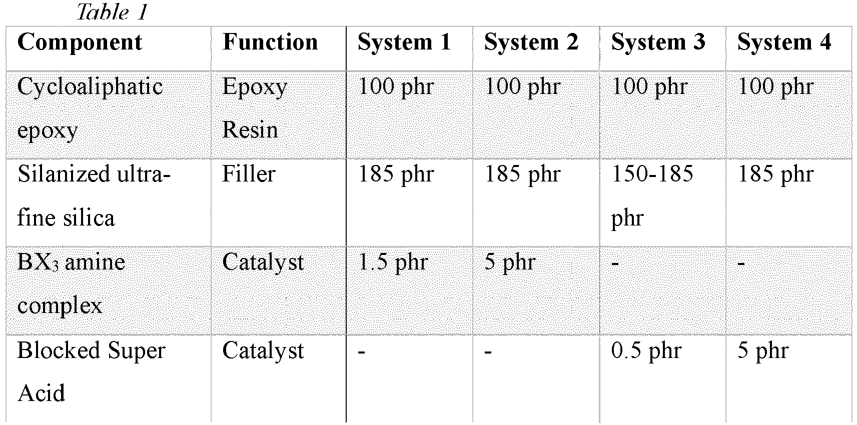

In the following, the measuring and test methods of the samples are described.

Tracking and erosion: Steel plates with a spacer (20*22*0.6 cm) were used as a mold for testing tracking and erosion. The steel plates are preheated at 70 °C before casting the mixture. The tracking and erosion testing at 3.5 kV followed. According to the inclined tracking and erosion test (class 1A3.5, IEC 60587), a sample is considered to have successfully passed the test when the leakage current does not overcome 60 mA for more than 2 seconds in a period of 6 hours.

Cracking resistance: Steel inserts with two different radii of 1 mm and 10 mm and a height of 50 mm and breadth and width to 40 mm were used for determining the cracking resistance. Disposable metal cans with an internal diameter of 80 mm and a height of around 55 mm were used as molds to produce the specimens. For the crack sensitivity evaluation, the samples were temperature cycled in 10 °C steps to temperatures between 0 °C and -70 °C. A temperature ramp of 1 K/minute was used to cool the samples from 20 °C to the set-point temperature. A dwell-time of 120 minutes was used at the set-point temperature and a ramp of 10 K/minute to heat the samples back to 20 °C. The samples were examined visually for cracks at each return to 20 °C.

In the following, the results of the measurements are described.

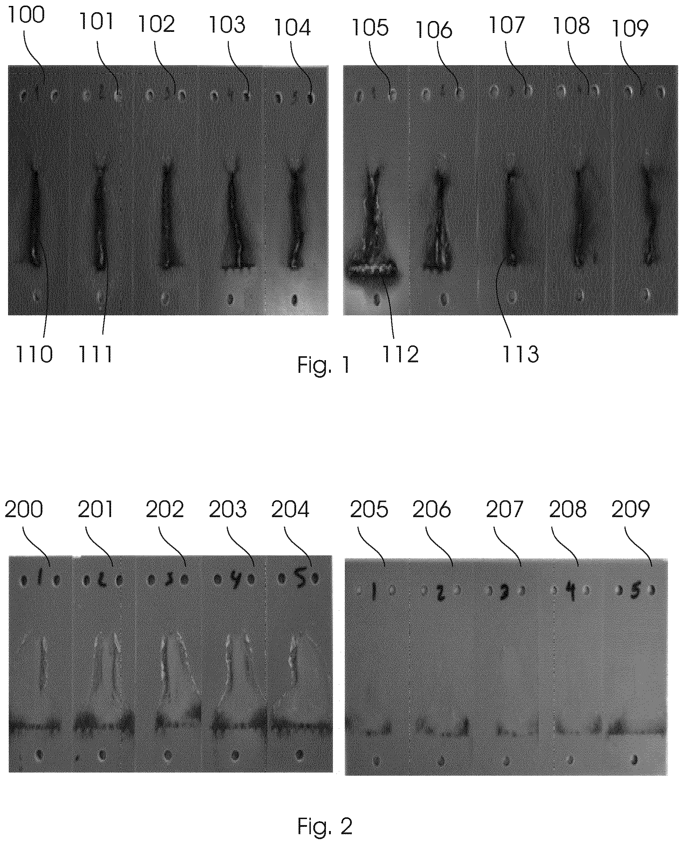

Fig. 1 shows (for comparison purposes) samples as known in the art that failed the tracking and erosion test. The samples 100 to 109 of Fig. 1 are prepared with an epoxy resin composition known in the art and being different from the epoxy resin composition as used and described in embodiments described herein. In particular, the ten samples of Fig. 1 are cured with various catalyst systems different from the catalyst system as used and described in embodiments herein. The samples are shown after having failed the tracking and erosion test at 3.5kV The tracking and erosion traces are only denoted for some samples (100, 101, 105 and 107) with reference signs 110 to 113, but can be seen on all samples 100 to 109.

The samples in Fig. 1 only show qualitatively the erosion of samples 100 to 109 in greyscale after the tracking and erosion tests (leakage current at certain voltage running over the sample while the sample is also rinsed with a saline solution). The test is performed according to and explained in detail in standard IEC 60587. According to some embodiments, one can assume that a badly eroded sample (such as a sample having a large damaged area in Fig. 1) may have experienced a breakdown (and that the test is terminated by the test device if the leakage current overcomes 60 mA for more than 2 seconds in a period of 6 hours).

By contrast, as shown in Fig. 2, all samples 200 to 209 produced with the catalyst system of the present invention (i.e. system 1-2 as shown in table 1 above) fulfilled the above criteria for tracking and erosion and passed the test at 4.5 kV. In particular, the samples 200 to 204 are cured with BX₃ amine complexes (2 phr). The samples 205 to 209 are cured with blocked super acids (0.5 phr). All samples passed at 3.5 kV and 4.5 kV (according to standard IEC 60587). In Fig. 2, it can be seen that the samples are not damaged. Some traces of the test can be seen on the samples 200 to 209; however, the traces have not damaged the insulation or the sample.

The white traces indicated on some of the samples are residues from the saline solution running of the sample during testing. The white traces have no impact on the evaluation of the results.

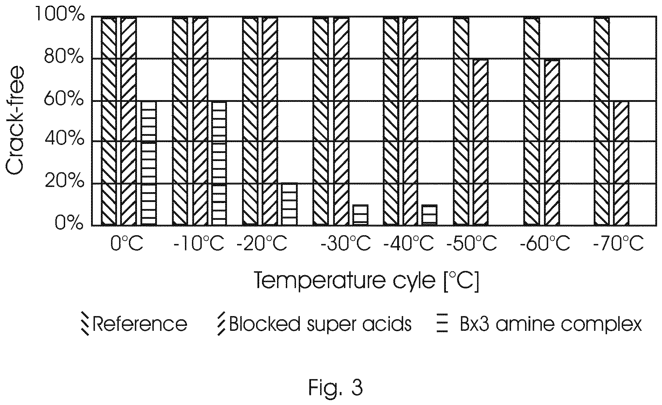

The low-temperature-resistance of the epoxy resin composition according to embodiments described herein after the described temperature cycles is shown in Fig. 3. The epoxy resin samples cured with blocked super acids withstand low temperatures up to -40 °C, and 60% of the samples also -70 °C without cracking. By contrast, the samples cast with BX₃ amine complexes show a less resistance for low temperatures.

According to an embodiment, the invention may further relate to a dielectric film comprising the electrical insulation material, in particular the epoxy resin composition as used in embodiments described herein. According to a further aspect, the dielectric film has a dielectric strength of at least about 10 kV/mm to about 40 kV/mm.

The epoxy resin composition used in embodiments described herein helps to prevent and avoid the risks of using volatile anhydrides in resin mixtures, in particular the risk of sensitization. Omitting anhydrides in the epoxy resin composition used in embodiments described herein avoids health issues due to sensitization. Further, as shown and discussed above, the epoxy resin composition as used in embodiments described herein provides the beneficial mechanical and electrical properties as known materials using anhydrides.

Though the present invention has been described on the basis of some preferred embodiments, those skilled in the art should appreciate that those embodiments should by no way limit the scope of the present invention.

## Claims

1. Use of an epoxy resin composition in an outdoor application of an electrical insulation, the epoxy resin composition comprising:
- an aliphatic epoxy resin;
- a catalyst system, wherein the catalyst system is present in a content of 0.5 -5 phr in the epoxy composition;
o the catalyst system comprising a BX₃ amine complex; the "X" in BX₃ standing for a halogenide;
wherein the epoxy resin composition is anhydride-free.

2. Use of an epoxy resin composition in a medium and high voltage application of an electrical insulation, the epoxy resin composition comprising:
- an aliphatic epoxy resin;
- a catalyst system, wherein the catalyst system is present in a content of 0.5 -5 phr in the epoxy composition and the catalyst system comprising a BX₃ amine complex, the "X" in BX₃ standing for a halogenide; wherein the epoxy resin composition is anhydride-free.

3. The use according to any of the preceding claims, wherein the BX₃ amine complex is a N,N-dimethyl-octyl amino complex of boron trichloride or derivatives of a N,N-dimethyl-octyl amino complex of boron trichloride.

4. The use according to any of the preceding claim, wherein the catalyst system includes both a BX₃ amine complex and a blocked super acid.

5. The use according to any of the preceding claims, wherein the content of the BX₃ amine complex in the composition is between 1.5 phr and 3 phr.

6. The use according to any of the preceding claims, wherein the resin is a hydrophobic resin.

7. The use according to any of the preceding claims, wherein the aliphatic resin is a cycloaliphatic resin.

8. The use according to any of the preceding claims, wherein the aliphatic epoxy resin is based on a diglycidyl ester of hexahydrophthalic acid.

9. The use according to any of the preceding claims, wherein the epoxy resin composition is a homopolymerized epoxy resin composition.

10. The use according to any of the preceding claims, wherein the use in outdoor applications comprises the use in a temperature range not below -40°C and not above +70°C, a humidity up to 100%, a UV index up to 11, and/or a salinity of the ambient air up to 200000 microSiemens/cm.

11. The use according to any of the preceding claims, wherein the use of the epoxy resin composition comprises the use in at least one of: in medium and/or high-voltage insulations for outdoor use, support insulators, current and voltage transformers and sensors, bushings, as impregnating resins, for outdoor insulators associated with high-voltage lines, in long-rods, in composite and cap-type insulators, in base insulators, in the production of insulators associated with outdoor power switches, in measuring transducers, in lead-throughs, in overvoltage protectors, in switchgear constructions, in power switches, dry-type transformers and electrical machines, in coating materials for transistors and other semiconductor elements.

12. The use according to any of the preceding claims, wherein the epoxy resin composition passes the the inclined tracking and erosion test according to standard IEC 60587, class 1A3.5 at 3.5 kV and 4.5 kV.

13. The use according to any of the preceding claims, wherein the epoxy resin composition withstands temperatures minimum -40°C without cracking.

14. A power product for outdoor applications comprising an electrical insulation with a homopolymerized epoxy resin composition, comprising:
- a hydrophobic, cycloaliphatic resin;
- a catalyst system, wherein the catalyst system is present in a content of 0.5 -5 phr in the epoxy composition;
∘ the catalyst system comprisinga BX₃ amine complex, the "X" in BX₃ standing for a halogenide;
wherein the epoxy resin composition is anhydride-free.

## Patentansprüche

1. Verwendung einer Epoxidharzzusammensetzung bei einer Freiluftanwendung einer elektrischen Isolierung, wobei die Epoxidharzzusammensetzung Folgendes umfasst:
- ein aliphatisches Epoxidharz;
- ein Katalysatorsystem, wobei das Katalysatorsystem in einem Gehalt von 0,5-5 phr in der Epoxidzusammensetzung vorliegt;
∘ das Katalysatorsystem umfasst einen BX₃-Amin-Komplex; das "X" in BX₃ steht für ein Halogenid;
wobei die Epoxidharzzusammensetzung anhydridfrei ist.

2. Verwendung einer Epoxidharzzusammensetzung bei einer Mittel- und Hochspannungsanwendung einer elektrischen Isolierung, wobei die Epoxidharzzusammensetzung Folgendes umfasst:
- ein aliphatisches Epoxidharz;
- ein Katalysatorsystem, wobei das Katalysatorsystem in einem Gehalt von 0,5-5 phr in der Epoxidzusammensetzung vorliegt und das Katalysatorsystem einen BX₃-Amin-Komplex umfasst; das "X" in BX₃ steht für ein Halogenid;
wobei die Epoxidharzzusammensetzung anhydridfrei ist.

3. Verwendung nach einem der vorhergehenden Ansprüche, wobei es sich bei dem BX₃-Amin-Komplex um einen N,N-Dimethyloctylaminokomplex von Bortrichlorid oder Derivate eines N,N-Dimethyloctylaminokomplexes von Bortrichlorid handelt.

4. Verwendung nach einem der vorhergehenden Ansprüche, wobei das Katalysatorsystem sowohl einen BX₃-Amin-Komplex als auch eine blockierte Supersäure umfasst.

5. Verwendung nach einem der vorhergehenden Ansprüche, wobei der Gehalt des BX₃-Amin-Komplexes in der Zusammensetzung zwischen 1,5 phr und 3 phr liegt.

6. Verwendung nach einem der vorhergehenden Ansprüche, wobei es sich bei dem Harz um ein hydrophobes Harz handelt.

7. Verwendung nach einem der vorhergehenden Ansprüche, wobei es sich bei dem aliphatischen Harz um ein cycloaliphatisches Harz handelt.

8. Verwendung nach einem der vorhergehenden Ansprüche, wobei das aliphatische Epoxidharz auf einem Diglycidylester von Hexahydrophthalsäure basiert.

9. Verwendung nach einem der vorhergehenden Ansprüche, wobei es sich bei der Epoxidharzzusammensetzung um eine homopolymerisierte Epoxidharzzusammensetzung handelt.

10. Verwendung nach einem der vorhergehenden Ansprüche, wobei die Verwendung bei Freiluftanwendungen die Verwendung in einem Temperaturbereich nicht unter -40 °C und nicht über +70 °C, bei einer Feuchtigkeit von bis zu 100 %, einem UV-Index von bis zu 11 und/oder einer Salinität der Umgebungsluft von bis zu 200.000 Mikrosiemens/cm umfasst.

11. Verwendung nach einem der vorhergehenden Ansprüche, wobei die Verwendung der Epoxidharzzusammensetzung die Verwendung in mindestens einem von: Mittel- und/oder Hochspannungsisolierungen für Freilufteinsatz, Stützisolatoren, Strom- und Spannungswandlern und -sensoren, Buchsen, als Imprägnierharze, für Freiluftisolatoren im Zusammenhang mit Hochspannungsleitungen, in Langstäben, in Verbund- und Kappenisolatoren, in Sockelisolatoren, bei der Herstellung von Isolatoren im Zusammenhang mit Freiluft-Leistungsschaltern, in Messwandlern, in Durchführungen, in Überspannungsschutzgeräten, im Schaltanlagenbau, in Leistungsschaltern, in Trockentransformatoren und elektrischen Maschinen, in Beschichtungsmaterialien für Transistoren und anderen Halbleiterelementen umfasst.

12. Verwendung nach einem der vorhergehenden Ansprüche, wobei die Epoxidharzzusammensetzung den Schräglauf- und Erosionstest gemäß der Norm IEC 60587, Klasse 1A3.5, bei 3,5 kV und 4,5 kV besteht.

13. Verwendung nach einem der vorhergehenden Ansprüche, wobei die Epoxidharzzusammensetzung Temperaturen von minimal -40 °C ohne Rissbildung widersteht.

14. Leistungsprodukt für Freiluftanwendungen, umfassend eine elektrische Isolierung mit einer homopolymerisierten Epoxidharzzusammensetzung, umfassend:
- ein hydrophobes cycloaliphatisches Harz;
- ein Katalysatorsystem, wobei das Katalysatorsystem in einem Gehalt von 0,5-5 phr in der Epoxidzusammensetzung vorliegt;
∘ das Katalysatorsystem umfasst einen BX₃-Amin-Komplex; wobei das "X" in BX₃ für ein Halogenid steht;
wobei die Epoxidharzzusammensetzung anhydridfrei ist.

## Revendications

1. Utilisation d'une composition de résine époxy dans une application extérieure d'une isolation électrique, la composition de résine époxy comprenant :
- une résine époxy aliphatique ;
- un système catalyseur, le système catalyseur étant présent à une teneur de 0,5-5 phr dans la composition époxy ;
∘ le système catalyseur comprenant un complexe aminé BX₃, le « X » dans BX₃ représentant un halogénure ;
dans laquelle la composition de résine époxy est dépourvue d'anhydride.

2. Utilisation d'une composition de résine époxy dans une application moyenne et haute tension d'une isolation électrique, la composition de résine époxy comprenant :
- une résine époxy aliphatique ;
- un système catalyseur, le système catalyseur étant présent à une teneur de 0,5-5 phr dans la composition époxy et le système catalyseur comprenant un complexe aminé BX₃, le « X » dans BX₃ représentant un halogénure ; dans laquelle la composition de résine époxy est dépourvue d'anhydride.

3. Utilisation selon l'une quelconque des revendications précédentes, dans laquelle le complexe aminé BX₃ est un complexe N,N-diméthyl-octylamino de trichlorure de bore ou des dérivés d'un complexe N,N-diméthyl-octylamino de trichlorure de bore.

4. Utilisation selon l'une quelconque des revendications précédentes, dans laquelle le système catalyseur comporte à la fois un complexe aminé BX₃ et un superacide bloqué.

5. Utilisation selon l'une quelconque des revendications précédentes, dans laquelle la teneur du complexe aminé BX₃ dans la composition se situe entre 1,5 phr et 3 phr.

6. Utilisation selon l'une quelconque des revendications précédentes, dans laquelle la résine est une résine hydrophobe.

7. Utilisation selon l'une quelconque des revendications précédentes, dans laquelle la résine aliphatique est une résine cycloaliphatique.

8. Utilisation selon l'une quelconque des revendications précédentes, dans laquelle la résine époxy aliphatique est basée sur un ester diglycidylique d'acide hexahydrophtalique.

9. Utilisation selon l'une quelconque des revendications précédentes, dans laquelle la composition de résine époxy est une composition de résine époxy homopolymérisée.

10. Utilisation selon l'une quelconque des revendications précédentes, l'utilisation dans des applications extérieures comprenant une utilisation dans une plage de température supérieure ou égale à -40 °C et inférieure ou égale à +70 °C, une humidité allant jusqu'à 100 %, un indice UV allant jusqu'à 11, et/ou une salinité de l'air ambiant allant jusqu'à 200 000 pS/cm.

11. Utilisation selon l'une quelconque des revendications précédentes, l'utilisation de la composition de résine époxy comprenant une utilisation dans au moins une des applications suivantes : isolations moyenne et/ou haute tension pour utilisation extérieure, isolateurs supports, transformateurs et capteurs de courant et de tension, traversées isolées, comme résines d'imprégnation, pour isolateurs extérieurs associés à des lignes haute tension, dans de longues tiges, dans des isolateurs composites et de type coiffe, dans des isolateurs de base, dans la production d'isolateurs associés à des interrupteurs extérieurs, dans des transducteurs de mesure, dans des traversées, dans des protections contre les surtensions, dans des constructions d'appareillage de commutation, dans des interrupteurs, transformateurs et machines électriques de type sec, dans des matériaux de revêtement pour transistors et autres éléments semiconducteurs.

12. Utilisation selon l'une quelconque des revendications précédentes, dans laquelle la composition de résine époxy réussit le test de cheminement sur plan incliné et d'érosion conformément à la norme CEI 60587, classe 1A3.5 à 3,5 kV et 4,5 kV.

13. Utilisation selon l'une quelconque des revendications précédentes, dans laquelle la composition de résine époxy supporte des températures de -40 °C minimum sans fissurer.

14. Produit électrique pour applications extérieures comprenant une isolation électrique avec une composition de résine époxy homopolymérisée, comprenant :
- une résine cycloaliphatique hydrophobe ;
- un système catalyseur, le système catalyseur étant présent à une teneur de 0,5-5 phr dans la composition époxy ;
∘ le système catalyseur comprenant un complexe aminé BX₃, le « X » dans BX₃ représentant un halogénure ;
dans lequel la composition de résine époxy est dépourvue d'anhydride.
